# EUROPEAN PATENT APPLICATION

(11) **EP 2 595 316 A1**
(43) Date of publication of application: **22.05.2013**
(21) Application number: 12189087.5
(22) Date of filing: 18.10.2012
(51) Int. Cl.: H03K 17/06, H02M 3/155, H02M 3/158

(54) **Electronic device using a bootstrap circuit**

(30) Priority: 15.11.2011 TW 100141686
(71) Applicant: Lextar Electronics Corp., 30075 Hsinchu (TW)
(72) Inventor: Lai, Chien-Feng, 303 Hukou Township (TW)
(74) Representative: von Kreisler Selting Werner

(57) **Abstract**

An electronic device (fig. 3: 300) includes: a load (fig. 3: 320); and a bootstrap circuit (fig. 1: 110, fig. 3: 310), for driving the load, comprising: a first switch element (Q1), coupled to a first clock signal (CLK); a second switch element (D1), coupled to an operating voltage (VCC) and the first switch element; a third switch element (D2), coupled to the first switch element; a first charge storage unit (CB), coupled to the second and third switch elements; and a voltage converting unit (110), coupled to the first charge storage unit, and the first, second and third switch elements. When the first clock signal is at a first logic state (high level), the first charge storage unit is charged, when the clock signal is at a second logic state (low level), a cross voltage of the first charge storage unit ensures that the voltage converting unit converts an input voltage to an output voltage.

## Description

### BACKGROUND

### Technical Field

The application relates to a bootstrap circuit and an electronic device applying the same.

### Description of the Related Art

An electronic device operates with a connected power. A power circuit usually refers to a power circuit design that powers an electronic device. Power is categorized into a direct current (DC) power and an alternating current (AC) power.

A DC power circuit is mainly implemented by a switching converter, with a buck circuit being a most common structure. A buck converter utilizes an N-type metal-oxide-semiconductor (NMOS) transistor as a main conducting element. To ensure that an NMOS transistor stays unaffected from a set output voltage, an additional bootstrap circuit is usually provided. A conventional bootstrap circuit includes NMOS transistor as a capacitance charging path switch - such approach increases both production costs and circuit area.

The application is directed to a bootstrap circuit and an electronic device applying the bootstrap circuit. Without changing circuit output characteristics, another type of switch element is utilized to replace a costly metal-oxide-semiconductor field-effect transistor (MOSFET).

According to another example of the present application, an electronic device is provided. The electronic device includes a load and a bootstrap circuit for driving the load. The bootstrap circuit includes: a first switch element, coupled a clock signal; a second switch element, coupled to an operating voltage and the first switch element; a third switch element, coupled to the first switch element; a first charge storage unit, coupled to the second and third switch elements; and a voltage converting unit, coupled to the first charge storage unit as well as the first, second and third switch elements. When the clock signal is at a first logic state, the first charge storage unit is charged. When the clock signal is at a second logic state, a cross voltage of the first charge storage ensures that the voltage converting unit converts an input voltage to an output voltage.

The above and other contents of the application will become better understood with regard to the following detailed description of the preferred but non-limiting embodiments. The following description is made with reference to the accompanying drawings.

FIG. 1 is a schematic diagram of a bootstrap circuit according to one embodiment of the present application.

FIG. 2 is a diagram of waveforms of simulated results according to one embodiment of the present application.

FIG. 3 is a schematic diagram of an electronic device according to another embodiment of the present application.

### DETAILED DESCRIPTION OF THE APPLICATION

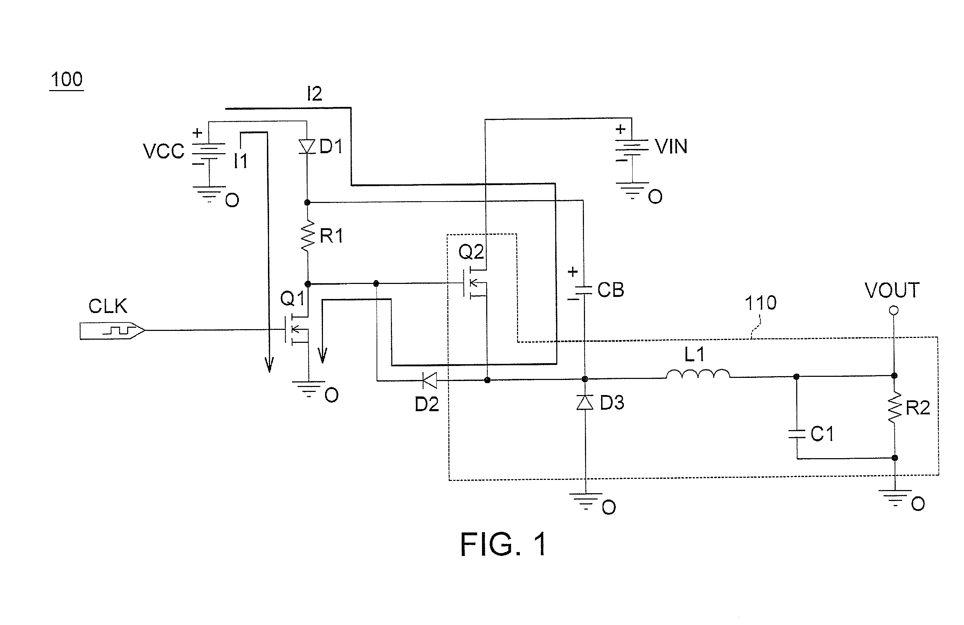

FIG. 1 shows a schematic diagram of a bootstrap circuit 100 according to one embodiment of the present application. Referring to FIG. 1, the bootstrap circuit 100 include: a first switch element Q1, coupled to a clock signal CLK; a second switch element D1, coupled to an operating voltage VCC and the first switch element Q1; a third switch element D2, coupled to the first switch element Q1; a first charge storage unit CB, coupled to the second switch element D1 and the third switch element D2; and a voltage converting unit 100, coupled to the first charge storage unit CB, the first switch element Q1, the second switch element D1 and the third switch element D2.

When the clock signal CLK is at a first logic state (e.g., a high level HIGH), the first switch element Q1 and the second switch element D1 conduct a first current path I1; and the operating voltage VCC, the first switch element Q1 and the second switch element D1 are on the first current path I1.

Further, when the clock signal CLK is at the first logic state (e.g., HIGH), the first switch element Q1, the second switch element D1 and the third switch element D2 conduct a second current path I2; and the operating voltage VCC, the second switch element D1, the first charge storage unit CB, the third switch element D2 and the first switch element Q1 are on the second current path, thereby charging the first charge storage unit CB.

In contrast, when the clock signal CLK is at a second logic state (e.g., a low level LOW), the first switch element Q1 is turned off, and a cross voltage of the first charge storage unit CB ensures that the voltage converting unit 110 converts an input voltage VIN to an output voltage VOUT.

In addition, the bootstrap circuit 100 may further include a current limiting unit R1 coupled between the first switch element Q1 and the second switch element D1. The current limiting unit R1 limits a current on the first current path I1.

In this embodiment, for example, the first switch element Q1 includes a first transistor Q1, which has a first terminal (drain) coupled to the current limiting unit R1, a second terminal (source) coupled to a ground terminal (GND), and a third terminal (gate) coupled to the clock signal CLK.

In this embodiment, for example, the second switch element D1 includes a first diode D1, which has a first terminal (anode) coupled to the operating voltage VCC and a second terminal (cathode) coupled to the current limiting unit R1. When the first charge storage unit CB is charged and the clock signal CLK is at HIGH, the voltage at the cathode of the first diode D1 becomes higher than the voltage at the anode (i.e., the operating voltage VCC) of the first diode D1. If no isolation, the voltage on the first charge storage unit CB would conflict with the operating voltage VCC. Therefore, in this embodiment, the first diode D1 isolates the first charge storage unit CB from the operating voltage VCC.

In this embodiment, for example, the third switch element D2 includes a second diode D2, which has a first terminal (anode) coupled to the first charge storage unit CB and a second terminal (cathode) coupled to the first switch element Q1.

In this embodiment, for example, the voltage converting unit 110 includes a buck circuit. The voltage converting unit 110 may include a fourth switch element, a fifth switch element, an inductor L1 and a second charge storage unit C1. For example, the fourth switch element includes a second transistor Q2, and is coupled to the input voltage VIN, the third switch element D2, the first switch element Q1, and the first charge storage unit CB. When the clock signal CLK is at the first logic state (i.e., HIGH), the fourth switch element Q2 is turned off. When the clock signal CLK is at the second logic state (i.e., LOW), the cross voltage of the first charge storage unit CB turns on the fourth switch element Q2. For example, the fifth switch element includes a third diode D3, and is coupled to the first charge storage unit CB. The inductor L1 is coupled to the first charge storage unit CB. The second charge storage unit C1 is coupled to the inductor L1.

The voltage converting unit 110 may further include a resistor R2 coupled between the output voltage VOUT and the ground terminal. The resistor R2, being an optional element, may serve as a load element.

In the description below, for illustrative purposes, for example, the operating voltage VCC is a 5V DC voltage, and the input voltage VIN is a 10V DC voltage. The bootstrap circuit 100 converts the input voltage (10V DC) to the output voltage VOUT (e.g., 3V DC).

More specifically, when the clock signal CLK is HIGH, the first transistor Q1 is conducted. Since the first transistor Q1 is conducted, the first transistor Q1 pulls low the gate voltage of the second transistor Q2 to GND, so that the second transistor Q2 becomes turned off. As previously stated, the first diode D1, the second diode D2 and the first transistor Q1 conduct the second current path I2. Since the first charge storage unit CB is on the second current path I2, the first charge storage unit CB is charged by the second current path I2. The cross voltage of the first charge storage unit CB is ΔVCB=(VCC-VD1-VD2-VDS1), where VD1 and VD2 respectively represent cross voltages of the diodes D1 and D2, and VDS1 represents a drain-source voltage of the first transistor Q1.

In addition, when the clock signal CLK is HIGH, the first current path I1 is formed (by the first diode D1 and the first transistor Q1 as previously stated). To prevent an overcurrent flowing through the first transistor Q1 and damaging the first transistor Q1, the current limiting unit R1 is used to limit the current flowing on the first current path I1. By so, the first transistor Q1 stays undamaged under that fact that the current flowing into the first transistor Q1 is limited.

In contrast, when the clock signal CLK is LOW, the first transistor Q1 is turned off, and the cross voltage ΔVCB of the first charge storage unit CB ensures that the second transistor Q2 is conducted. That is, when the clock signal CLK is LOW, ΔVCB>VGS2(Vth), where VGS2(Vth) represents a threshold voltage of the second transistor Q2. Since the second transistor Q2 is conducted when the clock signal CLK is LOW, the voltage converting unit 110 converts the input voltage VIN to the output voltage VOUT.

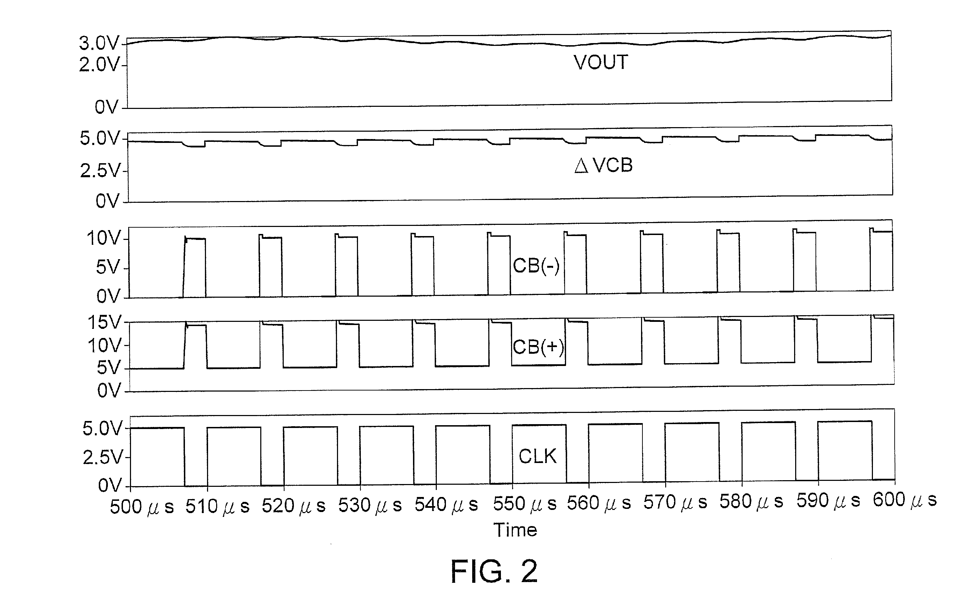

FIG. 2 shows a diagram of waveforms of simulated results according to one embodiment of the present application. In the diagram, waveforms CB(+) and CB(-) respectively represent the voltages at the first terminal (+) and the second terminal (-) of the first charge storage unit CB. It is observed from the waveforms of the simulated results that, without changing output characteristics, the bootstrap circuit of the present application is capable of converting the input voltage IN to the output voltage VOUT (i.e., maintaining the output voltage VOUT as 3V).

Further, the switch elements may also be implemented by operational amplifiers, as such modification is also encompassed within the spirit of the present application.

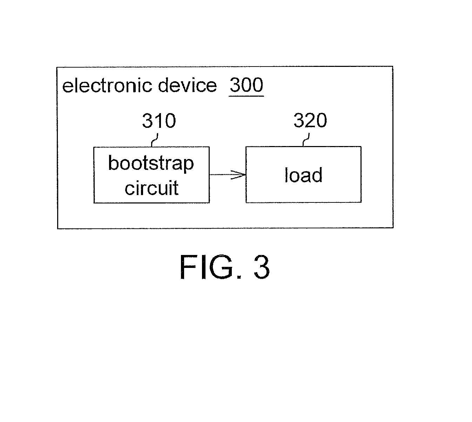

An electronic device is provided according to another embodiment of the present application. Referring to FIG. 3, an electronic device 300 according to another embodiment of the present application includes a foregoing bootstrap circuit 310 and a load 320. The bootstrap circuit 310 drives the load 320. For example, the electronic device 300 is a lighting equipment, and the load 320 is a light-emitting diode (LED).

Therefore, it is demonstrated in the above embodiments that, low-cost switch elements (e.g., diodes) are utilized to replace more costly switch elements (e.g., NMOS transistors). Thus, without changing output characteristics of the circuit, both costs and circuit area are reduced to increase product competitiveness.

It will be apparent to those skilled in the art that various modifications and variations can be made to the disclosed embodiments. It is intended that the specification and examples be considered as exemplary only, with a true scope of the disclosure being indicated by the following claims and their equivalents.

## Claims

1. An electronic device, comprising:
a load; and
a bootstrap circuit, for driving the load, comprising:
a first switch element, coupled to a first clock signal;
a second switch element, coupled to an operating voltage and the first switch element;
a third switch element, coupled to the first switch element;
a first charge storage unit, coupled to the second and third switch elements; and
a voltage converting unit, coupled to the first charge storage unit, and the first, second and third switch elements;
wherein, when the first clock signal is at a first logic state, the first charge storage unit is charged; and
when the clock signal is at a second logic state, a cross voltage of the first charge storage unit ensures that the voltage converting unit converts an input voltage to an output voltage.

2. The electronic device according to claim 1, wherein:
when the first clock signal is at the first logic state, the first and second switch elements conduct a first current path, and the operating voltage and the first and second switch elements are on the first current path; the first, second and third switch elements conduct a second current path, and the operating voltage, the second switch element, the first charge storage unit, and the third and first switch elements are on the second current path, so as to charge the first charge storage unit; and
when the clock signal is at the second logic state, the first switch element is turned off, and the cross voltage of the first charge storage unit ensures that the voltage converting unit converts the input voltage to the output voltage.

3. The electronic device according to claim 1, further comprising:
a current limiting unit, coupled between the first and second switch elements, for limiting a current flowing on the first current path.

4. The electronic device according to claim 3, wherein:
the first switch element comprises a first transistor, which has a first terminal coupled to the current limiting unit, a second terminal coupled to a ground terminal, and a third terminal coupled to the clock signal; and
the second switch element comprises a first diode, which has a first terminal coupled to the operating voltage and a second terminal coupled to the current limiting unit.

5. The electronic device according to claim 4, wherein the third switch element comprises a second diode, which has a first terminal coupled to the first charge storage unit and a second terminal coupled to the first switch element.

6. The electronic device according to claim 5, wherein the voltage converting unit comprises a buck circuit.

7. The electronic device according to claim 5, wherein the voltage converting unit comprises:
a fourth switch element, coupled to the input voltage, the third switch element and the first charge storage unit, the fourth switch element turned off when the clock signal is at the first logic state, and turned on by the cross voltage of the first charge storage unit when the clock signal is at the second logic state;
a fifth switch element, coupled to the first charge storage unit;
an inductor, coupled to the first charge storage unit; and
a second charge storage unit, coupled to the inductor.

8. The electronic device according to claim 7, wherein the voltage converting unit further comprises a resistor coupled between the output voltage and the ground terminal.
